Europäisches Patentamt

European Patent Office

Office européen des brevets

(11) Publication number: **0 386 283**
**A1**

# EUROPEAN PATENT APPLICATION

(21) Application number: **89103925.7**

(22) Date of filing: **06.03.89**

(51) Int. Cl.5: **H01L 39/24**

(43) Date of publication of application:
**12.09.90 Bulletin 90/37**

(84) Designated Contracting States:
**CH DE FR GB IT LI**

(71) Applicant: **THE TOKAI UNIVERSITY JURIDICAL FOUNDATION**
**28-4, 2-chome, Tomigaya**
**Shibuya-ku Tokyo(JP)**

Applicant: **NKK CORPORATION**
**1-2 Marunouchi 1-chome, Chiyoda-ku Tokyo(JP)**

(72) Inventor: **Tachikawa, Kyoji Department of Materials Science**
**The Tokai University Juridical Foundation, 1117**
**Kitakaname, Hiratsuka-City Kanagawa Pref(JP)**
Inventor: **Shinbo, Yukio c/o NKK Corporation**
**1-2, 1-chome Marunouchi**
**Chiyoda-ku Tokyo(JP)**
Inventor: **Matsuda, Yutaka c/o NKK Corporation**
**1-2, 1-chome Marunouchi**
**Chiyoda-ku Tokyo(JP)**
Inventor: **Kabasawa, Makoto c/o NKK Corporation**
**1-2, 1-chome Marunouchi**
**Chiyoda-ku Tokyo(JP)**
Inventor: **Kosuge, Shigeyoshi c/o NKK Corporation**
**1-2, 1-chome Marunouchi**
**Chiyoda-ku Tokyo(JP)**
Inventor: **Watanabe, Itaru c/o NKK Corporation**
**1-2, 1-chome Marunouchi**
**Chiyoda-ku Tokyo(JP)**

(74) Representative: **Henkel, Feiler, Hänzel & Partner**
**Möhlstrasse 37**
**D-8000 München 80(DE)**

(54) **Superconducting article.**

(57) A superconducting article comprising: a substrate made of nickel or a nickel alloy; and a film of a composite oxide superconducting material containing a $Cu_xO_y$-radical, formed on the surface of the substrate. In the above-mentioned superconducting article, cracks are hardly produced in the film of the composite oxide superconducting material, and oxygen in the composite oxide superconducting material is hardly absorbed into the substrate.

# SUPERCONDUCTING ARTICLE

## FIELD OF THE INVENTION

The present invention relates to a superconducting article which comprises a substrate and a film of a superconducting material, formed on the surface of the substrate.

## BACKGROUND OF THE INVENTION

Superconducting materials have already been practically applied in the form of a superconducting magnet in a particle accelerator, a medical diagnosing instrument and the like. Potential applications of the superconducting materials include an electric power generator, an energy storage, a linear motor car, a magnetic separator, a nuclear fusion reactor, a power transmission cable, and a magnetic shielder. In addition, a superconducting element using the Josephson effect is expected to be applied in such fields as an ultra-high speed computer, an infrared sensor and a low-noise amplifier. The magnitude of industrial and social impact, which would exert upon practical realization of these possibles application, is really unmeasurable.

One of the typical superconducting materials so far developed is an Nb-Ti alloy which is widely used at present as a magnetizing wire. The Nb-Ti alloy has a critical temperature (i.e., a critical temperature from which a superconductive state occurs) (hereinafter simply referred to as "Tc") of 9 K. As a superconducting material having a "Tc" considerably higher than that of the Nb-Ti alloy, a compound-type superconducting material has been developed, including an $Nb_3Sn$ (Tc: 18 K) and $V_3Ga$ (Tc: 15 K) which are now practically employed in the form of a wire.

As a superconducting material having a "Tc" further higher than those of the above-mentioned alloy-type and compound-type superconducting materials, a composite oxide superconducting material containing a $Cu_xO_y$-radical has recently been developed. For example, a Y-Ba-Cu-0 type superconducting material has a "Tc" of about 93 K. Since liquid nitrogen has a temperature of 77 K, liquid nitrogen available at a lower cost than liquid helium can be used as a cooling medium for the composite oxide superconducting material.

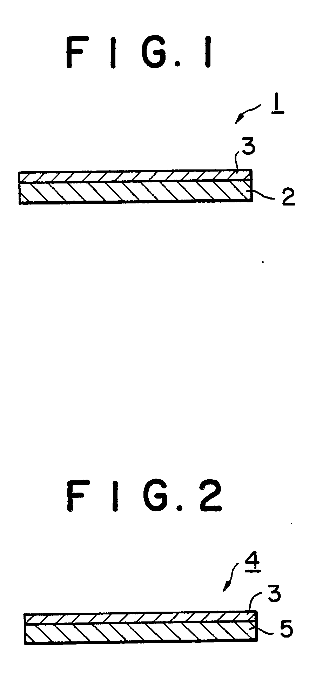

A conventional superconducting article 1 using a composite oxide superconducting material comprises, as shown in Fig. 1, a substrate 2 made of copper, and a film 3 of the above-mentioned superconducting material, formed on the surface of the substrate 2 by means of a known metallizing method with the use of a plasma phenomenon, as described later.

However, the above-mentioned conventional superconducting article 1 has the following problems: It is known that, in a composite oxide superconducting material such as $Y_1Ba_2Cu_3O_{7-y}$, the increase in an amount of oxygen omission "y" makes it impossible to obtain a film 3 of the superconducting material having a high "Tc" and a high critical current density (hereinafter simply referred to as "Jc"), i.e., having an excellent superconducting property. During the metallizing of the superconducting material on the surface of the substrate 2 and during the heating of the film 3 of the superconducting material after the metallizing thereof, oxygen is lost from the superconducting material, resulting in the increase in the amount of oxygen omission "y" of the superconducting material. It is therefore the conventional practice to reduce the amount of oxygen omission "y" of the superconducting material by heating and thus formed film 3 of the superconducting material to a temperature of about 950° C, and then slowly cooling the film 3 at a rate of up to 20° C/minute to cause the superconducting material to absorb oxygen. The film 3 is heated in an attempt to achieve a uniform structure of the superconducting material, intensify a connecting strength of grain boundaries, and increase an adhering strength between the substrate and the film 3. However because of the difference in a thermal expansion coefficient between the substrate 2 and the film 3 of the superconducting material, cracks may be caused in the film 3 during the metallizing of the superconducting material and during the above-mentioned heat treatment applied to the film 3 of the superconducting material after the metallizing thereof. Since the substrate 2 made of copper is easily oxidized, oxygen in the superconducting material is absorbed into the substrate 2 during application of the above-mentioned heat treatment to the film 3 of the superconducting material after metallizing thereof, thus often making it impossible to obtain a film 3 of the superconducting material excellent in a superconducting property.

Under such circumstances, there is a demand for development of a superconducting article in which cracks are not produced in a film of a composite oxide superconducting material formed on the surface of a substrate during the formation of the film on the surface of the substrate and during the heat treatment of the film, and oxygen in the composite oxide superconducting material is hardly absorbed into the substrate during the heat treatment of the film, but such a superconducting article has not as yet been proposed.

## SUMMARY OF THE INVENTION

An object of the present invention is therefore to provide a superconducting article in which cracks are not produced in a film of a composite oxide superconducting material formed on the surface of a substrate during the formation of the film on the surface of the substrate and during the heat treatment of the film, and oxygen in the composite oxide superconducting material is hardly absorbed into the substrate during the heat treatment of the film.

In accordance with one of the features of the present invention, in a superconducting article comprising:

a substrate; and

a film of a composite oxide superconducting material containing a $Cu_xO_y$-radical, formed on the surface of said substrate;

there is provided the improvement characterized in that:

said substrate is made of any one of nickel and a nickel alloy.

## BRIEF DESCRIPTION OF THE DRAWINGS

Fig. 1 is a sectional view illustrating a conventional superconducting article;

Fig. 2 is a sectional view illustrating the superconducting article of the present invention;

Fig. 3 is a schematic descriptive sectional view illustrating a known metallizing method with the use of a plasma phenomenon, which is available for manufacturing the superconducting article of the present invention;

Fig. 4 is a schematic descriptive sectional view illustrating a known vapor deposition method with the use of a laser beam, which is available for manufacturing the superconducting article of the present invention; and

Fig. 5 is a schematic descriptive sectional view illustrating an adhesion strength test of the film of the superconducting material in the superconducting article of the present invention.

## DETAILED DESCRIPTION OF PREFERRED EMBODIMENTS

From the point of view as described above, extensive studies were carried out to develop a superconducting article in which cracks are not produced in a film of a composite oxide superconducting material formed on the surface of a substrate during the formation of the film on the surface of the substrate and during the heat treatment of the film, and oxygen in the composite oxide superconducting material is hardly absorbed into the substrate during the heat treatment of the film. As a result, the following finding was obtained: It is possible to obtain a superconducting article in which cracks are not produced in a film of a composite oxide superconducting material formed on the surface of a substrate during the formation of the film on the surface of the substrate and during the heat treatment of the film, and oxygen in the composite oxide superconducting material is hardly absorbed into the substrate during the heat treatment of the film, by using a substrate made of any one of nickel and a nickel alloy.

The present invention was made on the basis of the above-mentioned finding, and is characterized in that a substrate is made of any one of nickel and a nickel alloy, and that a film formed on the surface of the substrate comprises a composite oxide superconducting material containing $Cu_xO_y$-radical.

The superconducting article of the present invention is described below with reference to the drawings.

Fig. 2 is a sectional view illustrating the superconducting article of the present invention. As shown in Fig. 2, the superconducting article 4 of the present invention comprises a substrate 5 made of any one of nickel and a nickel alloy, and a film 3 of a composite oxide superconducting material containing a $Cu_xO_y$-radical, formed on the surface of the substrate 5.

According to the superconducting article of the present invention, since the substrate 5 is made of any one of nickel and a nickel alloy, cracks are not produced in the film 3 of the composite oxide superconducting material formed on the surface of the substrate 5 during the formation of the film 3 on the surface of the substrate 5 and ruing the heat treatment of the film 3. This is attributable to the fact that the thermal expansion coefficient of the substrate 5 made of any one of nickel and a nickel alloy is substantially equal to that of the film 3 of the superconducting material. Because the substrate 5 is made of any one of nickel and a nickel alloy, oxygen in the film 3 of the composite oxide superconducting material is hardly absorbed into the substrate 5 during the heat treatment of the film 3. This is due to the fact that the substrate 5 made of any one of nickel and a nickel alloy is less oxidizable than the conventional substrate made of copper.

As the above-mentioned nickel alloy, for example, an alloy of nickel and chromium is used.

Now, some known methods available for manufacturing the sueprconducting article of the present invention are described with reference to the drawings.

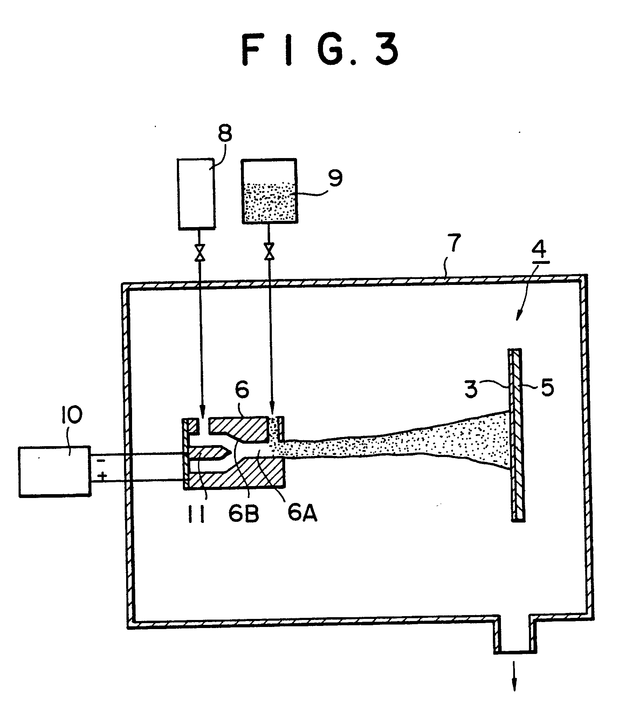

Fig. 3 is a schematic descriptive sectional view illustrating a known metallizing method with the use of a plasma phenomenon, which is available for manufacturing the superconducting article of the present invention. In Fig. 3, 6 is a metallizing nozzle provided in a container 7, 8 is a pressure tank for storing an operating gas, 9 is a reservoir for storing powder of a superconducting material, 5 is a substrate arranged vertically in the container 7 so as to face the metallizing nozzle 6, and 10 is an electric power source provided outside the container 7.

As shown in Fig. 3, an inert gas such as an argon gas is continuously supplied as the operating gas from the pressure tank 8 through a rear end portion of the metallizing nozzle 6 into a bore 6A thereof. Powder of a composite oxide superconducting material such as $Y_1Ba_2Cu_3O_{7-y}$ containing $Cu_xO_y$-radical is continuously supplied from the reservoir 9 through a tip portion of the metallizing nozzle 6 into the bore 6A thereof. An electric current is supplied from the electric power source 10 to an electrode 11 inserted into a rear end portion of the bore 6A of the metallizing nozzle 6 to produce an electric arc between the electrode 11 and an inner surface 6B of the bore 6A of the metallizing nozzle 6 so as to convert the operating gas supplied into the bore 6A into a high-temperature plasma. The powder of the superconducting material supplied into the bore 6A of the metallizing nozzle 6 is melted by means of the operating gas converted into the high-temperature plasma. The thus melted powder of the superconducting material is uniformly blown from the metallizing nozzle 6 onto the surface of the substrate 5 made of nickel or a nickel alloy, which is arranged in the container 7 so as to face the metallizing nozzle 6, by means of a jet of the operating gas converted into the high-temperature plasma, whereby a film 3 of the superconducting material is formed on the surface of the substrate 5 to manufacture the superconducting article 4 of the present invention.

Then, the film 3 of the composite oxide superconducting material thus formed on the surface of the substrate 5 is heated to a temperature of about 950°C, and then the film 3 is slowly cooled at a rate of up to 20°C per minute to cause the superconducting material to absorb oxygen.

According to the superconducting article 4 of the present invention manufactured as described above, since the substrate 5 is made of any one of nickel and a nickel alloy, cracks are not produced in the film 3 of the composite oxide superconducting material formed on the surface of the substrate 5 during the formation of the film 3 on the surface of the substrate 5 and during the heat treatment of the film 3, and oxygen in the composite oxide superconducting material is hardly absorbed into the substrate 5 during the heat treatment of the film 3. It is therefore possible to obtain a superconduc-

ting article 4 comprising the substrate 5 and the film 3 excellent in a superconducting property, formed on the surface of the substrate 5.

Then, another known method available for manufacturing the superconducting article of the present invention is described with reference to the drawing.

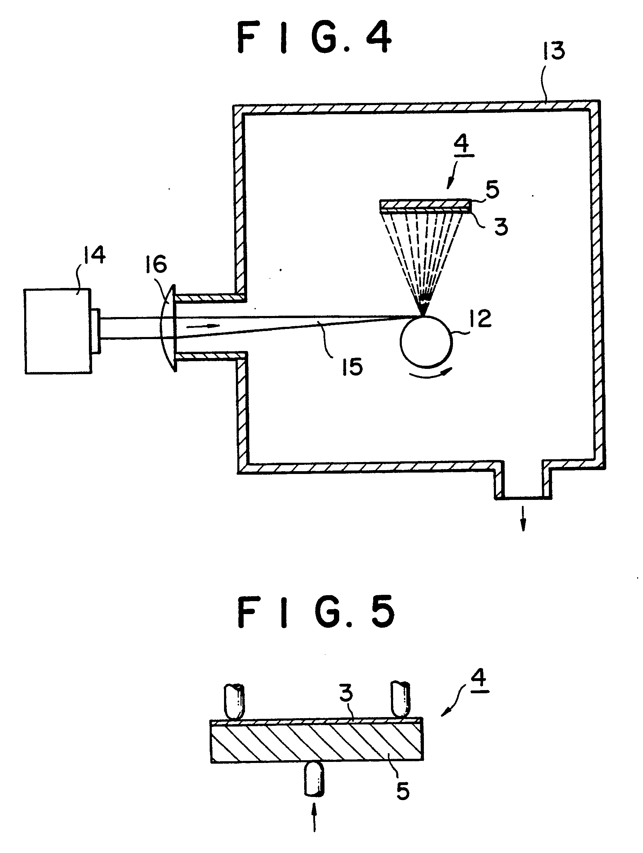

Fig. 4 is a schematic descriptive sectional view illustrating a known vapor deposition method with the use of a laser beam, which is available for manufacturing the superconducting article of the present invention. In Fig. 4, 12 is a vaporization source of a composite oxide superconducting material, provided in a container 13; 5 is a substrate arranged horizontally above the vaporization source 12; and 14 is a laser beam source for projecting a laser beam 15 toward the vaporization source 12 in the container 13.

As shown in Fig. 4, the laser beam 15 is projected from the laser beam source 14 through a condensing lens 16 provided in the container 13 toward the vaporization source 12 for producing a vapor of the composite oxide superconducting material such as $Y_1Ba_2Cu_3O_{7-y}$ containing a $Cu_xO_y$-radical, in the container 13. The vaporization source 12 is heated to a high temperature by means of the laser beam 15 to produce the vapor of the composite oxide superconducting material, which in turn adheres to the surface of the substrate 5, whereby, a film 3 of the superconducting material is formed on the surface of the substrate 5 to manufacture the superconducting article 4 of the present invention.

Then, the film 3 of the composite oxide superconducting material thus formed on the surface of the substrate 5 is heated to a temperature of about 950°C, and then the film 3 is slowly cooled at a rate of up to 20°C per minute to cause the superconducting material to absorb oxygen.

According to the thus-manufactured superconducting article 4 of the present invention, as in the case where the superconducting article of the present invention is manufactured by the metallizing method with the use of the plasma phenomenon presented above, it is possible to obtain a superconducting article 4 comprising the substrate 5 and the film 3 excellent in a superconducting property, formed on the surface of the substrate 5.

Now, the superconducting article of the present invention is described further in detail by means of examples.

## EXAMPLE 1

As shown in Fig. 3, a substrate 5 made of nickel having a transverse width of 30 mm, a longitudinal width of 20 mm and a thickness of 1.0 mm was vertically arranged in a container 7 so as to face a metallizing nozzle 6. An argon gas as the working gas was continuously supplied from a pressure tank 8 through a rear end portion of the metallizing nozzle 6 into a bore 6A thereof while keeping the pressure in the container 7 at 60 Torr. Powder having a particle size of from 10 to 100 $\mu$m of a composite oxide superconducting material comprising $Y_1Ba_2Cu_3O_{7-y}$ , was continuously supplied form a reservoir 9 through a tip portion of the metallizing nozzle 6 into the bore 6A thereof. An electric power of 25 KWH was supplied from an electric power source 10 provided outside the container 7 to an electrode 11 inserted into a rear end portion of the bore 6A of the metallizing nozzle 6 to produce an electric arc between the electrode 11 and an inner surface 6B of the inner bore 6A of the metallizing nozzle 6 so as to convert the operating gas supplied into the bore 6A into a high-temperature plasma. The powder of the superconducting material supplied into the bore 6A of the metallizing nozzle 6 was melted by means of the operating gas converted into the high-temperature plasma. The thus melted powder of the superconducting material was uniformly blown form the metallizing nozzle 6 onto the surface of the substrate 5 by means of a jet of the operating gas converted into the high-temperature plasma, whereby a film 3 having a thickness of 150 $\mu$m of the superconducting material was formed on the surface of the substrate 5 to manufacture the superconducting article 4 of the present invention.

Subsequently, the film 3 of the superconducting material thus formed on the surface of the substrate 5 was heated to a temperature of 930°C for 30 minutes in a heating furnace under an oxygen-containing atmosphere (not shown) provided outside the container 7, and then slowly cooled to the room temperature at a cooling rate of 20°C/minute.

Then, the critical temperature "Tc" and the temperature at which the Meissner effect appeared of the film 3 of the superconducting material, were investigated. As a result, the film 3 had a critical temperature "Tc" of 85 K, and the Meissner effect appeared at 77K.

Then, the presence of cracks produced in the film 3 of the superconducting material and strength of the film 3 were investigated. Strength of the film 3 was evaluated by means of a bending angle of the film 3, at which cracks occurred in the film 3 in a three-point bending test as shown in Fig. 5 applied to a test piece of the superconducting article 4. As a result, no occurrence of cracks was observed in the film 3, and cracks did not occur until the bending angle reached 4.4 degrees.

EXAMPLE 2

As shown in Fig. 4, a substrate 5 made of Ni-Co alloy having a transverse width of 30 mm, a longitudinal width of 20 mm and a thickness of 1.0 mm was horizontally arranged above a vaporization source 12 of the composite oxide superconducting material in a container 13. A $CO_2$ gas laser beam 15 was continuously projected from a laser beam source 14 provided outside the container 13 through a condensing lense 16 provided in the container 13 toward the vaporization source 12 for producing a vapor of the composite oxide superconducting material such as $Y_1Ba_2Cu_3O_{7-y}$ containing a $Cu_xO_y$-radial, while keeping the pressure in the container 13 at $10^{-1}$ Torr. The vaporization source 12 was heated to a high temperature by means of the laser beam 15 to produce the vapor of the composite oxide superconducting material, which in turn adhered to the surface of the substrate 5, whereby a film 3 having a thickness of 5 $\mu$m of the superconduc-ting material was formed on the surface of the substrate 5 to manufacture the superconducting article 4 of the present invention.

Subsequently, the film 3 of the superconducting material thus formed on the surface of the substrate 5 was subjected to a heat treatment under the same conditions as in Example 1.

Then, the critical temperature "Tc" and the tmeperature at which the Meissner effect appeared of the film 3 of the superconducting material, were investigated. As a result, the film 3 had a critical temperature "Tc" of 88 K, and the Meissner effect appeared at 77 K.

Then, the presence of cracks produced in the film 3 of the superconducting material and strength of the film 3 were investigated. Strength of the film 3 was tested and evaluated in the same manner as in the Example 1. As a result, no occurrence of cracks was observed in the film 3, and cracks did not occur until the bending angle reached 8.1 degrees.

According to the present invention, as described above in detail, since the substrate is made of any one of nickel and a nickel alloy, cracks are not produced in the film of the composite oxide superconducting material formed on the surface of the substrate during the formation of the film on the surface of the substrate and during the heat treatment of the film, and oxigen in the composite oxide superconducting material is hardly absorbed into the substrate during the heat treatment of the film. It is therefore possible to obtain a superconducting article comprising a substrate and a film excellent in a superconducting property, formed on the surface of the substrate, thus providing industrially useful effects.

## Claims

1. In a superconducting article comprising:
a substrate; and
a film of a composite oxide superconducting material containing a $Cu_xO_y$-radical, formed on the surface of said substrate;
the improvement characterized in that:
said substrate is made of one of nickel and a nickel alloy.

# F I G. 1

_1_

3

2

# F I G. 2

_4_

3

5

# F I G. 3

# F I G. 4

# F I G. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | JAPANESE JOURNAL OF APPLIED PHYSICS, vol. 27, no. 6, June 1988, pages L1092-L1093, Tokyo, JP; T. KONAKA et al.: "Preparation of Y-Ba-Cu-O superconducting tape by atmospheric plasma spraying" <br> * Page L1092, paragraph 2 * | 1 | H 01 L 39/24 |
| A | APPLIED PHYSICS LETTERS, vol. 53, no. 7, 15th August 1988, pages 603-605, American Institute of Physics, New York, US; N.P. BANSAL et al.: "High Tc screen-printed YBa2Cu3O7-x films: Effect of the substrate material" <br> * Page 603, paragraph 3 * | 1 | |

TECHNICAL FIELDS
SEARCHED (Int. Cl.5)

H 01 L 39

The present search report has been drawn up for all claims

| Place of search | Date of completion of the search | Examiner |
|---|---|---|
| THE HAGUE | 18-07-1989 | HAMMEL E.J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)